## Europäisches Patentamt
## European Patent Office
## Office européen des brevets

(11) Numéro de publication: **0 332 516**
A1

# DEMANDE DE BREVET EUROPEEN

(21) Numéro de dépôt: 89400603.0

(22) Date de dépôt: 03.03.89

(51) Int. Cl.4: **C 30 B 15/00**
C 30 B 15/02, C 30 B 29/40

(30) Priorité: 11.03.88 FR 8803186

(43) Date de publication de la demande:
13.09.89 Bulletin 89/37

(84) Etats contractants désignés: **DE GB IT SE**

(71) Demandeur: **THOMSON HYBRIDES ET MICROONDES**
**173, bld Haussmann**
**F-75008 Paris (FR)**

(72) Inventeur: **Raffet, Claude Thomson-CSF**
**SCPI 51, Esplanade du Général de Gaulle**
**F-92 045 Paris la Défense Cedex 67 (FR)**

Bonnet, Michel Thomson-CSF
SCPI 51, Esplanade du Général de Gaulle
F-92 045 Paris la Défense Cedex 67 (FR)

Guilbert, Laurent Thomson-CSF
SCPI 51, Esplanade du Général de Gaulle
F-92 045 Paris la Défense Cedex 67 (FR)

Visentin, Nicole Thomson-CSF
SCPI 51, Esplanade du Général de Gaulle
F-92 045 Paris la Défense Cedex 67 (FR)

Courant, Evelyne Thomson-CSF
SCPI 51, Esplanade du Général de Gaulle
F-92 045 Paris la Défense Cedex 67 (FR)

(74) Mandataire: **Taboureau, James et al**
**THOMSON-CSF SCPI**
**F-92045 PARIS LA DEFENSE CEDEX 67 (FR)**

(54) Dispositif de synthèse et tirage de matériaux III-V, sous basse pression et procédé mettant en oeuvre ce dispositif.

(57) Dispositif de synthèse et tirage de matériaux III-V, tel que GaAs, sous basse pression, sans refroidissement ni manipulation complexe entre les étages de synthèse et le tirage.

Il comporte une ampoule de quartz de forme annulaire : une enveloppe (8) torique et un injecteur (12 + 13) annulaire sont concentriques avec une tige (19) de tirage de monocristal. L'ampoule est munie d'ergots intérieurs (16) et extérieurs (17) qui coopèrent avec des ergots (20) portés par la tige (19) et (24) par l'enceinte extérieure (23). La tige (19) permet de descendre l'ampoule dans la phase de synthèse, puis de la remonter et l'accrocher à l'enceinte dans la phase de tirage d'un monocristal.

Application au tirage des lingots de GaAs.

FIG.3

EP 0 332 516 A1

## Description

## DISPOSITIF DE SYNTHESE ET TIRAGE DE MATERIAUX III-V, SOUS BASSE PRESSION ET PROCEDE METTANT EN OEUVRE CE DISPOSITIF

La présente invention concerne un dispositif de synthèse et de tirage des composés III-V tel que GaAs en appareil de type Czochralski, sous basse pression. Ce dispositif, qui se présente sous la forme d'une ampoule de quartz, a une géométrie particulière qui permet de réaliser, dans un premier temps, la synthèse de GaAs puis, dans un deuxième temps, de tirer un lingot de GaAs monocristallin au moyen d'un germe fixé à une tige de tirage qui est concentrique à l'ampoule, celle-ci étant simplement translatée le long de la tige. L'invention concerne également le procédé utilisant ce dispositif.

La réalisation de lingots de GaAs monocristallins se fait actuellement selon deux procédés.

Dans la technique dite haute pression, le gallium, liquide à 28°C, et l'arsenic qui se sublime à 620°C, sont chauffés en creuset et encapsulés sous une pression de 35 atmosphères, d'où il s'ensuit que l'arsenic devient liquide. La réaction de formation de GaAs est exothermique.

Mais le taux de dislocation dans les monocristaux ainsi fabriqués est supérieur à $10^4 cm^{-2}$, ce qui est plus important que pour les monocristaux de silicium, et ce taux de dislocation cristalline est dû au gradient de température : il diminue lorsque $\Delta t$ diminue.

Par ailleurs, la température de fusion de GaAs est 1238°C et à cette température la pression partielle de l'arsenic au dessus de GaAs est 0,9 atm., ce qui implique qu'on puisse faire la synthèse et le tirage de GaAs sous une pression d'une atmosphère environ, et non plus 35 atm. comme dans le procédé haute pression.

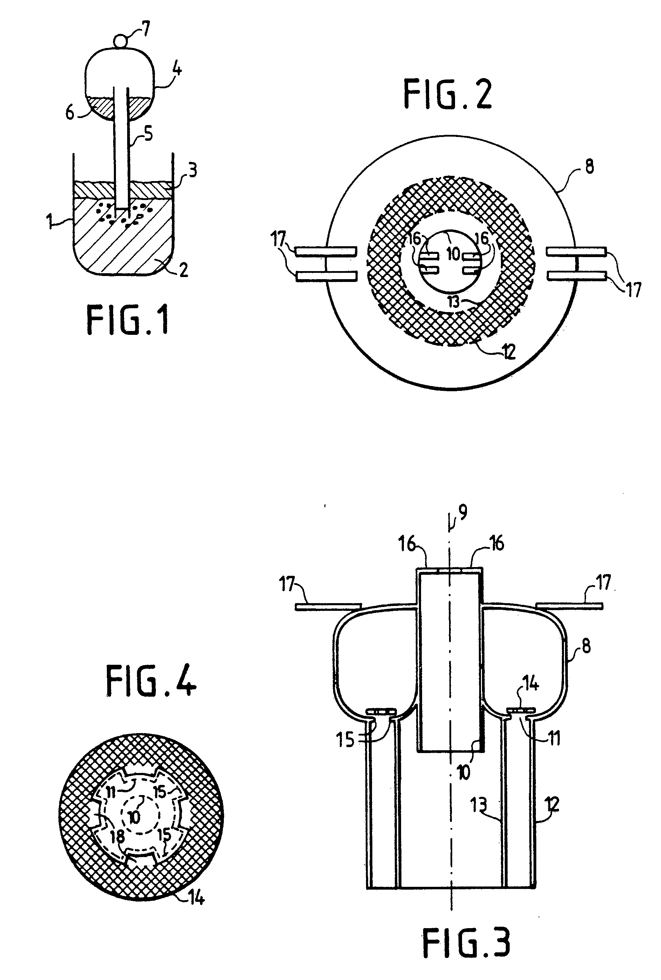

Cette seconde technique sous basse pression est déjà mise en oeuvre selon un processus rappelé en figure 1. A l'intérieur d'une enceinte, qui n'est pas représentée sur la figure 1, et qui permet de contrôler la pression d'un gaz neutre, un creuset de nitrure de bore 1 reçoit une charge de gallium solide 2, recouverte par une couche 3 d'oxyde de bore $B_2O_3$ pour limiter l'évaporation d'arsenic. Une ampoule 4 de quartz munie d'un injecteur 5, qui est un tube centré sur l'ampoule, reçoit une charge d'arsenic solide 6. L'ampoule est maintenue au-dessus ou descendue dans le gallium par des moyens non représentés, mais qui s'accrochent sur l'anneau 7 placé au sommet de l'ampoule. Dans cette technique connue l'arsenic est chauffé jusqu'à une température qui permet sa sublimation et les vapeurs d'arsenic distillent à travers le gallium liquéfié lui aussi par chauffage. La réaction est assez difficile à contrôler parce qui l'arsenic vaporisé sort de l'ampoule par seulement un tube central, et le gallium liquide monte et descend dans le tube 5 selon des mouvements erratiques. Mais surtout ce type d'ampoule nécessite une enceinte extérieure complexe, munie de vannes tiroirs ou d'une tige de manipulation supplémentaire pour pouvoir retirer l'ampoule après formation de GaAs. En effet, l'ampoule 4 occupe une position centrée par rapport au creuset 2 dans lequel est formé le composé binaire GaAs et il est nécessaire d'évacuer l'ampoule 4 pour pouvoir ensuite présenter une tige qui porte un germe cristallin et tirer un lingot de GaAs monocristallin. Ceci nécessite une vanne tiroir ou une tige de manipulation supplémentaire, qui fait partie intégrante de l'enceinte, pour évacuer l'ampoule 4 vide d'arsenic et présenter la tige de tirage : il y a donc une étape supplémentaire entre les deux étapes de synthèse et de tirage et en outre une certaine complication de l'enceinte.

Le dispositif selon l'invention, basé sur la technique de distillation à basse pression, entre 1 et 10 atmosphère, permet de simplifier l'enceinte et le processus, les deux étapes de synthèse et de tirage se faisant sans refroidissement intermédiaire. L'ampoule de distillation de l'arsenic a une forme adaptée qui permet à la tige de tirage du monocristal de passer à travers l'ampoule : tige et ampoule sont coaxiales. De plus, l'ampoule est munie d'un double jeu d'ergots intérieurs et extérieurs par rapport à son axe. Les ergots intérieurs coopèrent avec un ergot porté en bout de tige de tirage, qui devient ainsi un moyen de manipulation de l'ampoule pour l'amener à proximité du bain de gallium, ou pour la translater vers le haut de l'enceinte pendant la phase de tirage. Les ergots extérieurs coopèrent avec des ergots portés par l'enceinte pour y accroc'er l'ampoule pendant ladite phase de tirage. Enfin, l'injecteur de l'ampoule a 'ui aussi une forme coaxiale, ce qui autorise une plus grande surface de contact entre l'arsenic et la gallium, et donne une réaction plus rapide et mieux contrôlable.

De façon plus précise, l'invention concerne un dispositif de synthèse et tirage de matériaux III-V, tel que GaAs, sous basse pression, comportant, à l'intérieur d'une enceinte à atmosphère neutre contrôlée, au moins une ampoule de synthèse du composé III-V par évaporation d'un premier constituant (As) dans un second constituant (Ga), et au moins une tige de tirage d'un lingot de monocristal, ce dispositif étant caractérisé en ce que l'ampoule de synthèse et la tige de tirage sont coaxiales, l'ampoule ayant une forme annulaire et permettant un passage sans frottement de la tige selon son axe.

L'invention sera mieux comprise par la description plus détaillée qui suit maintenant de l'ampoule de distillation de l'arsenic et du procédé, cette description s'appuyant sur les figures jointes en annexe qui représentent :

    - figure 1 : schéma simplifié du procédé de synthèse par distillation selon l'art connu, exposé précédemment,

    - figures 2 et 3 : vues en plan et en coupe respectivement de l'ampoule de synthèse des matériaux III-V selon l'invention,

    - figure 4 : vue en plan de la grille de retenue de l'arsenic dans l'ampoule, selon l'invention.

    - figure 5 : schéma de la position de l'ampoule au cours de l'étape de synthèse dans le procédé selon l'invention.

- figure 6 : schéma de la position de l'ampoule au cours de l'étape de tirage dans le procédé selon l'invention.

Le dispositif de synthèse et de tirage de monocristaux selon l'invention comporte essentiellement une ampoule dont la géométrie est adaptée, mais cette ampoule est indissociable d'une tige de tirage de monocristaux, elle aussi adaptée pour manipuler l'ampoule, ainsi que l'ergot porté par la paroi intérieure de l'enceinte dans laquelle sont faites les opérations. L'ampoule spéciale est représentée en figures 2 et 3 qui doivent être lues en conjonction.

L'ampoule de synthèse est constituée par une enveloppe 8, dont la forme de section n'est pas imposée, mais présentant une symétrie en tore autour de son axe 9. Par le centre de cette enveloppe 8, et coaxial avec elle, passe un tube 10 soudé sur l'enveloppe 8. Le diamètre de ce tube 10 doit être suffisant pour que la tige de tirage de monocristal passe librement à travers le tube.

La partie inférieure de l'enveloppe 8, c'est-à-dire celle qui est en regard du bain de gallium fondu au cours de l'opération, est entaillée par une ouverture circulaire 11. Sur l'enveloppe 8, et centré sur cette ouverture circulaire 11, est soudé l'injecteur qui est lui-même composé par deux tubes 12 et 13 qui sont coaxiaux avec l'axe de symétrie 9, de telle sorte que l'injecteur se présente en forme de couronne. Cette forme de couronne ressort mieux de la figure 2 sur laquelle les tubes 12 et 13 constitués en injecteurs sont rapportés en pointillé.

Pour pouvoir faire une synthèse de GaAs à partir de gallium déposé dans le creuset en nitrure de bore et à partir d'arsenic, il est nécessaire de maintenir l'arsenic à l'intérieur de l'enveloppe 8, tout au moins au début de l'opération et tant que l'arsenic n'a pas été totalement sublimé. Le remplissage de l'ampoule de verre s'effectue très simplement en la renversant et en introduisant l'arsenic dans l'enveloppe 8 au moyen de l'injecteur 12 + 13. L'orifice annulaire 11 est alors bouché au moyen d'une grille 14, dont le détail est donné en figure 4 et qui sera analysé ultérieurement. Cette grille 14 a donc obligatoirement des dimensions qui lui permettent de passer à travers l'injecteur, et pour l'empêcher de retomber elle est maintenue en place par des ergots 15 de l'ampoule, qui coopèrent avec les ergots dont la grille est munie.

Enfin l'ampoule de synthèse selon l'invention est munie d'ergots 16, dits intérieurs parce qu'ils sont portés par l'intérieur du tube 10. Ces ergots vont par paire, constitués par deux bâtonnets de quartz soudés sur le tube 10 et ils permettent à un ergot porté lui-même par la tige de tirage d'abaisser ou de relever l'ampoule.

L'enveloppe 8 est enfin munie d'un second jeu d'ergots 17 dits extérieurs parce qu'ils portent sur le diamètre extérieur de l'enveloppe 8. Comme les ergots 16, les ergots extérieurs sont également formés par paire, et ils permettent d'accrocher l'ampoule, lorsque la synthèse est terminée, sur des ergots qui sont portés par la paroi intérieure de l'enceinte. Les ergots 16, comme les ergots 17, sont préférablement constitués par des tiges de quartz soudées : la présence de deux ergots permet de bien stabiliser la position du moyen de manipulation ou du moyen d'accrochage par rapport aux deux ergots de section cylindrique.

En figure 4 est donnée plus en détail la représentation de la grille 14. Celle-ci peut être constituée soit par une plaque de quartz percée de trous, soit par une grille formée par des tiges de quartz et soudées sur deux anneaux extérieur et intérieur. Cette figure 4 a pour objet essentiel de montrer que la grille 14 est munie d'ergots 18, répartis sur sa circonférence intérieure, ces ergots 18 coopérant avec les ergots 15 portés par le bord du trou 11 dans l'enveloppe 8.

Il suffit après avoir introduit la grille 14 dans l'ampoule de la faire tourner pour que les ergots 18 s'appuient sur les ergots 15 et empêchent la grille de redescendre dans l'injecteur.

L'ensemble de l'ampoule de synthèse et de la grille qui maintient en place l'arsenic, qu'elle empêche de tomber sous l'effet de la gravité, est réalisé en quartz. On sait que le quartz, qui est à base de silice, dope légèrement de type N le GaAs synthétisé, mais seule la pointe de l'injecteur se trouve en contact avec le bain de gallium liquide, et le dopage apporté par la pointe de l'injecteur est peu significatif. La pointe de l'injecteur peut être protégée par un ou plusieurs manchons en nitrure de bore.

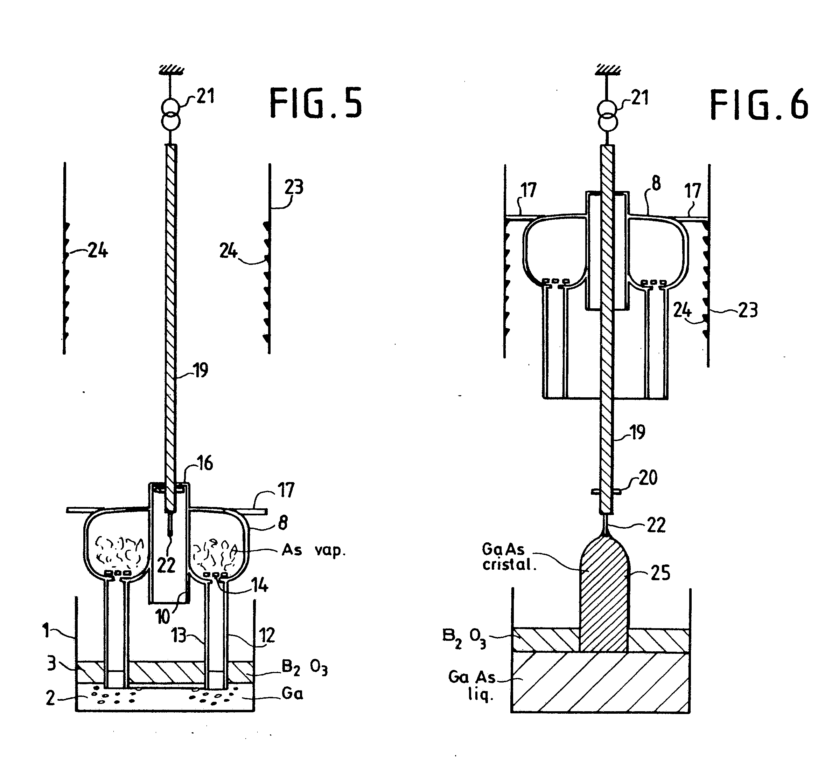

Les figures 5 et 6 représentent schématiquement les deux étapes de synthèse du composé III-V tel que GaAs et du tirage d'un monocristal de GaAs.

En figure 5, un creuset 1 de nitrure de bore pyrolytique contient du gallium 2 recouvert d'une couche 3 d'oxyde de bore $B_2O_3$. A l'intérieur d'une enceinte qui n'est pas représentée mais qui permet de maintenir le tout en atmosphère neutre contrôlée, l'ampoule 8 remplie d'arsenic est descendue au contact du gallium au moyen d'une tige 19, munie d'un ergot 20 dans sa partie inférieure. Cet ergot 20, qui se présente comme un cylindre transversalement par rapport à l'axe de la tige 19 vient trouver sa position entre les ergots 16 portés par le tube 10 de l'ampoule de synthèse. Par conséquent la tige 19 permet de soutenir, et de descendre ou de remonter l'ampoule de synthèse selon la phase de l'opération.

La tige 19 est elle-même maintenue à son extrémité supérieure par un capteur de poids 21, symboliquement représenté par deux anneaux déformables, et sur lequel on reviendra par la suite.

Dès le début de l'opération de synthèse de GaAs, la tige 19 est déjà munie à son extrémité inférieure d'un germe de GaAs monocristallin, en 22.

L'enceinte à l'intérieur de laquelle s'opère la synthèse comporte au moins une paroi intérieure et des moyens 23, qui sont munis d'ergots 24, sur un diamètre et à des dimensions correspondant aux ergots 17 portés par l'ampoule 8. Ces ergots 24 peuvent être eux aussi des éléments de cylindre, de telle sorte qu'un ergot 24 vient se bloquer entre deux ergots 17, lorsque l'ampoule est en position haute.

Durant l'opération de synthèse de GaAs, l'ampoule remplie d'arsenic, est descendue jusqu'à ce que l'injecteur 12 + 13 arrive en contact avec le gallium. L'ensemble est chauffé à une température suffisante pour vaporiser l'arsenic et amorcer la réaction : les vapeurs d'arsenic passant à travers la grille 14, réagissent à la base de l'injecteur avec le gallium liquide et forment GaAs, sous une pression régulée entre 1 et 3 bars absolus. Lorsque tout l'arsenic est vaporisé la tige 19 permet de remonter l'ampoule 8 , car l'ergot 20 qui passe sous les ergots 16 est un moyen de translation vertical de l'ampoule 8. Lorsque l'ampoule est remontée en haut de l'enceinte un mouvement de rotation permet de faire passer les ergots 17 de l'ampoule par dessus les ergots 24 de l'enceinte et ainsi de suspendre l'ampoule par coopération entre les ergots 17 et 24. Par conséquent et par opposition à l'art connu l'ampoule de distillation d'arsenic est effacée et la tige de tirage d'un monocristal peut prendre sa place : cette tige de tirage est précisément la tige 19 qui permet de manipuler l'ampoule.

C'est ce qui est représenté en figure 6 sur laquelle l'ampoule vide d'arsenic est maintenue en haut de l'enceinte, et la tige de tirage 19 est remontée peu à peu au fur et à mesure que se forme un lingot de GaAs monocristallin 25.

Il a été précisé que la tige 19 est maintenue à son extrémité supérieure au moyen d'un capteur de poids 21. Celui-ci permet de mieux contrôler la réaction en pesant l'ampoule. En effet, la réaction de combinaison entre l'arsenic et le gallium se passe de façon plus calme, et le gallium monte ou descend légèrement à l'intérieur de l'injecteur 12 + 13. A cette différence de hauteur Δh du gallium à l'intérieur de l'injecteur correspond une différence de poids de l'ampoule : la variation de poids de l'ampoule est une fonction également de l'épuisement de l'arsenic à l'intérieur de l'ampoule, et le capteur de poids permet non seulement de peser le poids d'arsenic consommé, mais également d'assurer une régulation par exemple sur la température de l'élément de chauffage qui distille l'arsenic pour contrôler le réaction de synthèse.

Ainsi la géométrie particulière de l'ampoule de synthèse de GaAs permet dans un matériel simple, n'ayant qu'un seul chauffage commun pour le gallium et l'arsenic et dépourvu de toute vanne tiroir ou disposition mécanique complexe, de tirer également un lingot monocristallin par simple translation de l'ampoule de synthèse, puisque celle-ci est concentrique avec la tige de tirage, cette tige de tirage ayant la double fonction de moyen de manipulation de l'ampoule et de tirage du monocristal de GaAs.

**Revendications**

1. Dispositif de synthèse et tirage de matériaux III-V, tel que GaAs, sous basse pression, comportant, à l'intérieur d'une enceinte à atmosphère neutre contrôlée, au moins une ampoule de synthèse de composé III-V par évaporation d'un premier constituant (As) dans un second constituant (Ga), et au moins une tige de tirage d'un lingot de monocristal, ce dispositif étant caractérisé en ce que l'ampoule de synthèse (8 + 12 + 13) et la tige de tirage (19) sont coaxiales, l'ampoule ayant une forme annulaire et permettant un passage sans frottement de la tige (19) selon son axe.

2. Dispositif selon la revendication 1, caractérisé en ce que l'ampoule de synthèse est formée par une enveloppe (8) torique, ouverte à la partie inférieure selon un anneau (14), et par un injecteur soudé sur l'enveloppe (8) sur les bords de l'ouverture ou anneau (14), l'injecteur étant lui-même formé de deux tubes (12,13) coaxiaux avec l'ampoule (8) et ayant une section annulaire, un tube central (10) traversant l'enveloppe (8) et étant coaxial avec elle et avec l'injecteur.

3. Dispositif selon la revendication 2, caractérisé en ce qu'une grille (14) maintient le premier constituant (As) dans l'enveloppe (8), ladite grille étant munie d'ergots (18) qui coopèrent avec des ergots (15) solidaires de l'enveloppe (8) pour la maintenir en place.

4. Dispositif selon la revendication 2, caractérisé en ce que le tube central (10) est muni d'au moins deux paires d'ergots (16), intérieurs par rapport au tube (10).

5. Dispositif selon la revendication 2, caractérisé en ce que l'enveloppe (8) est munie d'au moins deux paires d'ergots (17), extérieurs par rapport à la circonférence de l'enveloppe (8), lesdits ergots (17) étant soudés sur la face supérieure de l'enveloppe (8).

6. Dispositif selon la revendication 1, caractérisé en ce que la tige de tirage (19) est munie d'au moins un ergot (20), qui coopère avec es ergots (16) du tube central (10) de l'ampoule.

7. Dispositif selon la revendication 1, caractérisé en ce que l'enceinte comporte des moyens (23) munis d'une pluralité d'ergots (24), qui coopèrent avec les ergots (17) extérieurs à l'ampoule.

8. Dispositif selon la revendication 1, caractérisé en ce que la tige (19) de tirage est suspendue à un capteur de poids (21), qui permet de peser l'ampoule lorsqu'elle est soutenue par la tige de tirage (19).

9. Dispositif selon l'une quelconque des revendications 1 à 6, caractérisé en ce que l'ampoule, la grille et les ergots sont en quartz.

10. Procédé de synthèse et tirage d'un lingot de matériau III-V tel que GaAs, sous basse pression entre 1 et 10 atmosphères, à l'intérieur d'une enceinte sous atmosphère contrôlée, caractérisé en ce qu'il comporte les étapes suivantes :

a) - un premier constituant (As) étant introduit dans l'enveloppe (8) de l'ampoule et maintenu par la grille (14), l'ampoule est descendue au moyen de la tige (19) de tirage, déjà munie d'un germe cristallin (22) du composé à synthétiser, et par coopération des ergots intérieurs (16) de l'ampoule et des ergots (20) de la tige (19), jusqu'à ce que l'injecteur (12 + 13) de l'ampoule entre en contact avec le second constituant (Ga) contenu dans un creuset (1).

b) - l'ensemble est chauffé pour que le premier constituant s'évapore et entre en contact avec le second constituant et forme un composé chimique.

c) - à la fin de la distillation contrôlée par le capteur de masse (21) auquel sont accrochées l'ampoule et la tige de tirage, le chauffage étant maintenu pour que le composé formé reste liquide, l'ampoule est remontée dans l'enceinte au moyen de la tige (19) de tirage, et accrochée par ses ergots extérieurs (17) aux ergots (24) solidaires de l'enceinte (23).

d) - la tige (19) de tirage est descendue jusqu'à ce que le germe cristallin (22) qu'elle porte à son extrémité inférieure entre en contact avec le composé formé (GaAs) maintenu liquide, puis est lentement remontée pour tirer un lingot monocristallin.

FIG.1

FIG.2

FIG.4

FIG.3

FIG.5

FIG.6

GaAs cristal.

GaAs liq.

$B_2 O_3$

As vap.

$B_2 O_3$

Ga

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | PATENT ABSTRACTS OF JAPAN, vol. 10, no. 235 (C-366)[2291], 14 août 1986; & JP-A-61 68 394 (HITACHI CABLE LTD) 08-04-1986 * Résumé * --- | 1,2 | C 30 B  15/00 C 30 B  15/02 C 30 B  29/40 |
| A | JOURNAL OF CRYSTAL GROWTH, vol. 59, no. 3, octobre 1982, pages 665-668, North-Holland Publishing Co., Amsterdam, NL; J.-P. FARGES: "A method for the "in-situ" synthesis and growth of indium phosphide in a czochralski puller" * Figure 4; page 668 * --- | 1,2 | |
| A | EP-A-0 186 213  (SUMITOMO ELECTRIC INDUSTRIES LTD) * Page 24, ligne 25 - page 25, ligne 13; figure 4a; revendications 9-11,14 * ----- | 1,2,9 | |

| DOMAINES TECHNIQUES RECHERCHES (Int. Cl.4) |
|---|
| C 30 B |

Le présent rapport a été établi pour toutes les revendications

| Lieu de la recherche | Date d'achèvement de la recherche | Examinateur |
|---|---|---|
| LA HAYE | 06-06-1989 | COOK S.D. |